# FASCICULE DE BREVET EUROPEEN

(11) **EP 0 478 072 B1**
(45) Date de publication et mention de la délivrance du brevet: **02.08.1995**
(21) Numéro de dépôt: 91202419.7
(22) Date de dépôt: 19.09.1991
(51) Int. Cl.: H01L 21/32, H01L 23/544

(54) **Procédé pour réaliser des motifs d'alignement de masques**
Verfahren zur Herstellung von Markierungen zum Alignieren von Marken
Process for making alignment marks for masks

(30) Priorité: 28.09.1990 FR 9011979
(43) Date de publication de la demande: 01.04.1992
(73) Titulaire: Philips Electronics N.V., 5621 BA Eindhoven (NL)
(72) Inventeur: van der Plas, Paulus, Société Civile S.P.I.D., F-75008 Paris (FR); Lifka, Herbert, Société Civile S.P.I.D., F-75008 Paris (FR); Verhaar, Robertus, Société Civile S.P.I.D., F-75008 Paris (FR)
(74) Mandataire: Charpail, François

(56) Documents cités:
- EP-A- 0 335 074
- JP-A-61 100 928
- US-A- 4 338 620
- IBM TECHNICAL DISCLOSURE BULLETIN, vol. 32, no. 10B., mars 1990, pages 314-315; "Method of simultaneously defining alignment marks and implantation regions"

## Description

La présente invention concerne un procédé pour réaliser des motifs d'alignement de masques sur une face active d'un substrat semiconducteur selon lequel on forme d'abord sur cette face active au moins une couche d'un matériau résistant à l'oxydation, puis on définit par un décapage localisé de cette couche des zones pour un isolement par un oxyde épais, dis oxyde de champ, en même temps que les motifs d'alignement, l'un et l'autre étant destinés à être soumis à une oxydation thermique durant laquelle le reste de la surface active est protégé de l'oxydation par une partie restante de la couche de matériau anti-oxydation, et lors d'une étape ultérieure, on réalise au moins à des emplacements qui contiennent les motifs d'alignement, emplacements dits fenêtres d'alignement, des dénivellations à la surface du substrat d'une profondeur déterminée.

Un procédé de ce genre est connu du document JP Abstract 61-100928, 157 E 439.

Selon le procédé connu, les motifs d'alignement sont définis en même temps que les zones d'isolement par oxyde de champ. On obtient ainsi un positionnement relatif de ces éléments qui est conforme à la précision de l'appareillage utilisé et donc exempt d'une erreur possible de ré-alignement à cette étape.

Dans la fabrication d'un microcircuit du type à transistors MOS, il s'agit en fait de la première opération de définition d'une structure localisée à la surface du substrat. Les opérations ultérieures de masquage nécessiteront un alignement des masques le plus précis possible par référence aux motifs d'alignement préétablis. Avec l'avènement des technologies submicroniques, il devient nécessaire de réduire le plus possible les erreurs de positionnement des masques par rapport aux motifs d'alignement définis sur le substrat et on se tourne, dans ce but, vers des méthodes optiques très élaborées qui procurent un alignement automatique, à 0,2»m près, au moyen de servomécanismes de haute précision.

Toutefois, de tels procédés d'alignement de masques requièrent nécessairement que les motifs d'alignement se présentent sous une forme géométrique et une profondeur de dénivellation optimales en vue de leur utilisation par un procédé optique basé sur la formation de figures d'interférence.

Le procédé connu repose sur la création de dénivellations par un décapage des motifs d'alignement utilisant comme masque des parties d'oxyde de champ réservées à cet effet.

Il en résulte que les motifs d'alignement sont alors composés de parties en dénivellation (dépressions) où le substrat est découvert, et d'autres parties qui sont recouvertes de l'oxyde de champ, ce qui présente des inconvénients pour la formation des figures d'interférences ayant un bon contraste. Il serait au contraire souhaitable d'obtenir des motifs d'alignement protégés par une couche d'oxyde, de préférence ayant une épaisseur uniforme, tout en conservant un minimum d'étapes opératoires. Par ailleurs, le document US-A-4 338 620 décrit un procédé pour réaliser des motifs d'alignement et des régions d'isolement par oxyde comportant la formation d'un masque anti-oxydation, la formation de dénivellations aux emplacements de ces dits motifs et régions, le dépôt de silicium polycristallin dans les dénivellations et l'oxydation superficielle de ce silicium polycristallin pour la formation d'une couche d'oxyde ayant une épaisseur égale sur lesdits motifs et régions. Toutefois, ce procédé connu met en jeu des étapes opératoires spécifiques, comme un dépôt de silicium polycristallin, ce qui représente un accroissement de la complexité du procédé ainsi qu'une augmentation corrélative du prix des dispositifs semiconducteurs obtenus de cette manière.

L'invention vise donc à procurer un procédé pour réaliser des motifs d'alignement en un nombre restreint d'étapes, qui ne présente pas les inconvénients mentionnés et dont la durée des traitements à haute température, soit limité au minimum requis pour la réalisation de l'oxyde de champ.

Ces buts sont atteints, selon l'invention, par un procédé conforme à la partie caractérisante de la revendication 1.

Ce procédé offre l'avantage de produire des motifs d'alignement protégés par une couche d'oxyde d'épaisseur uniforme. Par ailleurs les parties restantes de couche anti-oxydation sont préservées (en dehors des fenêtres d'alignement) et celles-ci peuvent être conservées lorsque cela s'avère utile dans la suite de l'élaboration des dispositifs. La précision de positionnement des motifs d'alignement par rapport aux zones d'oxyde de champs est optimale puisqu'elle résulte d'ouvertures pratiquées simultanément dans la couche anti-oxydation.

Selon un premier mode de mise en oeuvre de l'invention, le procédé se caractérise en ce que lesdites dénivellations sont réalisées par une étape spécifique d'oxydation thermique dans des conditions telles qu'elle conduit à une conversion en oxyde du semiconducteur sur une profondeur égale à ladite profondeur déterminée, et qu'après avoir mis à nu la surface du semiconducteur à l'intérieur desdites fenêtres d'alignement, on effectue l'étape d'oxydation déjà mentionnée pour la réalisation de l'oxyde de champ, qui est complémentaire de l'étape spécifique d'oxydation.

Dans ce mode de mise en oeuvre, les dénivellations produites à la surface du semiconducteur ont une profondeur contrôlable avec une exellente précision, typiquement ± 10nm. Ledit traitement spécifique d'oxydation thermique constitue alors une première étape de formation de l'oxyde de champ qui ne fournit qu'une fraction seulement de l'épaisseur finale désirée. Après la mise à nu de la surface du semiconducteur dans lesdites fenêtres d'alignement, l'étape d'oxydation thermique précédemment mentionnée, constitue alors une étape d'oxydation complémentaire aboutissant à un oxyde de champ d'épaisseur désirée à ce stade du processus d'élaboration, tandis que les motifs d'alignement sont recouverts d'une couche d'oxyde d'épaisseur homogène plus faible.

Un deuxième mode de mise en oeuvre du procédé selon l'invention se caractérise en ce que lesdites dénivellations sont réalisées par décapage sélectif, uniquement dans les fenêtres d'alignement qui sont délimitées au moyen d'un masque de résine photosensible, et en ce qu'on retire ensuite, dans lesdites fenêtres et avec le même masque, les parties restantes de couche anti-oxydation après quoi on retire le masque de résine photosensible et on procède à une seule étape d'oxydation thermique pour la réalisation de l'oxyde de champ.

Selon ce mode de mise en oeuvre du procédé, le décapage sélectif produisant les dénivellations est obtenu par une attaque dans un plasma ou encore dans une solution d'attaque sélective de préférence à vitesse d'attaque faible pour obtenir la précision désirée de la profondeur des dénivellations. Le masque de résine photosensible ne nécessite pas une précision rigoureuse de positionnement puisqu'il suffit que lesdites fenêtres d'alignement englobent les motifs d'alignement. Le traitement d'oxydation est ensuite réalisé en une seule fois et conduit à une épaisseur de couche d'oxyde qui est la même aussi bien sur les zones d'isolement (oxyde de champ) que sur les motifs d'alignement.

En variante de ce mode de mise en oeuvre du procédé, on peut également réaliser les dénivellations dans les zones d'isolement. Ce procédé se caractérise par le fait que lesdites dénivellations sont réalisées par décapage sélectif, en utilisant uniquement la couche anti-oxydation comme masque sélectif, en ce qu'on retire ensuite, uniquement dans les fenêtres d'alignement qui sont alors délimitées au moyen d'un masque de résine photosensible, les parties restantes de couche anti-oxydation, après quoi on retire le masque de résine photosensible et on procède à une seule étape d'oxydation thermique pour la réalisation de l'oxyde de champ.

Dans ce cas, l'oxyde de champ se trouve alors enfoncé dans le substrat d'une profondeur correspondant aux dénivellations ce qui peut présenter un avantage pour le processus d'élaboration du dispositif.

Avantageusement, la profondeur des dénivellations est voisine du 1/4 de la longueur d'onde de la lumière mise en oeuvre pour l'exploitation des motifs d'alignement, en général elle est comprise entre 100 et 150 nm et de préférence égale à 125 nm ± 10 nm. Ainsi, le contraste optique obtenu au cours des opérations ultérieures d'alignement de masques est le meilleur.

L'invention sera mieux comprise à l'aide de la description qui va suivre en regard des dessins annexés, et qui est relative à des exemples non limitatifs.

Sur les dessins,
- les figures 1 à 5 représentent, par des coupes schématiques, différentes étapes au cours du procédé de réalisation de motifs d'alignement de masques dans un premier exemple de mise en oeuvre de l'invention,
- les figures 6 à 8 montrent des vues analogues, relatives à un deuxième exemple de réalisation du procédé et,
- les figures 9 à 11 sont relatives à un troisième exemple de mise en oeuvre de l'invention.

Il est à noter que sur les figures, les proportions entre les différentes parties n'ont pas été respectées, par souci de clarté, et notamment les épaisseurs ont été notablement exagérées. Sur les différentes figures, les éléments qui se correspondent dans la même fonction sont affectés des mêmes signes de référence.

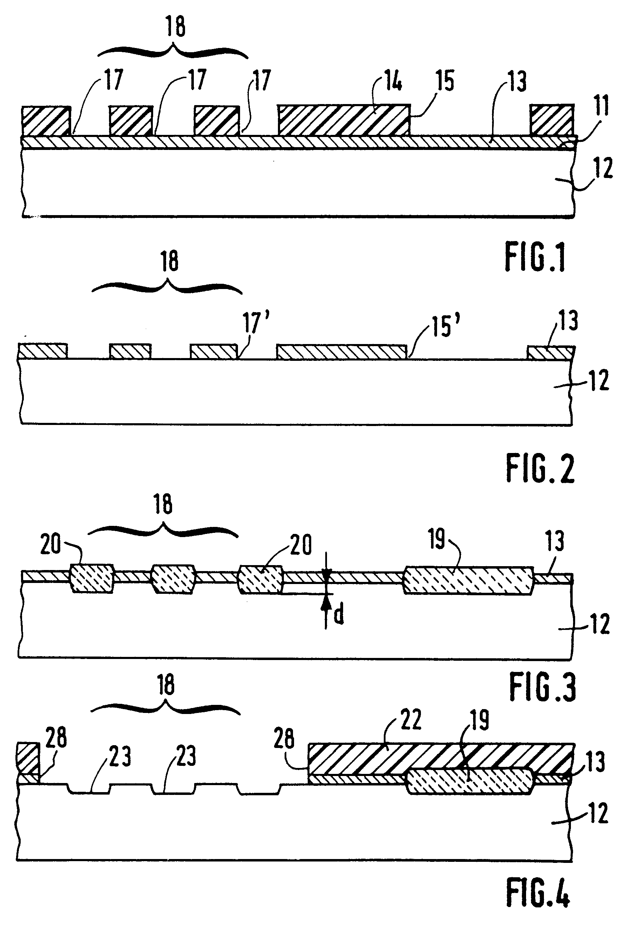

En se référant à la figure 1, sur une face active 11 d'un substrat semiconducteur 12, notamment en silicium monocristallin, une couche 13 en un matériau résistant à l'oxydation a été formée. La couche 13 telle que représentée sur les figures comme étant une couche homogène, est le plus souvent formée d'une succession d'une mince couche d'oxyde surmontée d'une couche de nitrure de silicium ou encore formée d'une couche d'oxy-nitrure de silicium ou par des couches successives de ces matériaux. L'ensemble est revêtu d'un masque de résine photosensible 14 présentant d'une part des ouvertures 15 correspondant à l'emplacement de zones d'isolement par oxyde de champ, et d'autre part une pluralité d'ouvertures 17 dont l'ensemble constitue un motif d'alignement de masques 18.

Les parties de la souche 13 de matériau anti-oxydation qui sont situées dans les ouvertures 15 et 17, sont retirées par décapage de préférence dans un plasma à base d'ions de fluor ou d'ions de chlore dans des conditions qui assurent un décapage sélectif par rapport au substrat ou par rapport à une sous-couche d'oxyde, le cas échéant. La couche anti-oxydation peut encore être gravée sélectivement dans un bain d'acide phosphorique chaud. Lorsque la couche 13 de matériau anti-oxydation comporte une sous-couche mince en oxyde de silicium, cette sous-couche peut être retirée ou non dans les ouvertures 15 et 17 ce qui n'entraîne aucune conséquence notable pour la suite du procédé.

Comme l'indique la figure 2, le masque 14 de résine photosensible est alors retiré et il subsiste les ouvertures 17′ et 15′ dans la couche 13. Le substrat de semiconducteur est soumis à un traitement d'oxydation thermique dans un four à 1000° environ pendant 40 mm sous une atmosphère constituée d'un mélange de vapeur d'eau et d'oxygène. Il se forme une couche d'oxyde localisé d'une part, une partie de couche 19 correspondant à l'emplacement des zones d'isolement par oxyde de champ et également des éléments localisés 20 d'oxyde à l'emplacement des motifs d'alignement 18. Les éléments localisés 19 et 20 d'oxyde ont une épaisseur d'environ 280 nm tandis que la dénivellation d créée par la conversion du semiconducteur en oxyde est environ égale à 125 nm. Le résultat obtenu à ce stade du procédé est représenté à la figure 3.

Le traitement d'oxydation thermique, qui vient d'être indiqué, est analogue à celui qui est généralement utilisé pour réaliser un oxyde de champ, mais dans le cas présent il s'agit d'une étape spécifique destinée à définir les motifs d'alignement 18 mais qui fournit en même temps une fraction de l'épaisseur finale désirée pour l'oxyde de champ.

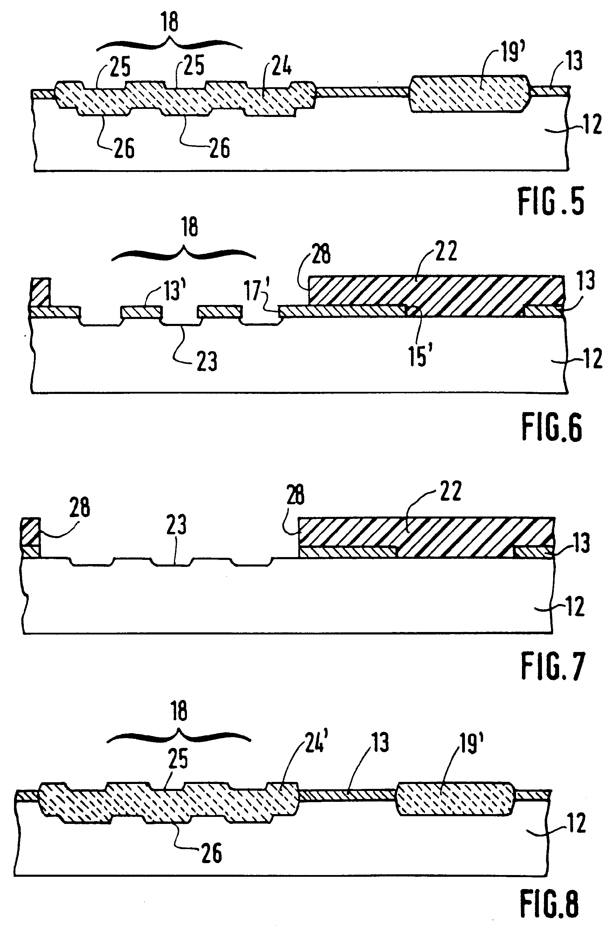

On se réfère maintenant à la figure 4 pour les étapes suivantes du procédé. L'ensemble précédent est revêtu d'un autre masque 22 de résine photosensible, muni de fenêtres 28 appelées "fenêtres d'alignement" qui englobent les positions des motifs d'alignement 18, tandis que le reste de la surface est protégé par ce masque 22. Puis la surface du semiconducteur dans lesdites fenêtres 28 est mise à nu par décapage sélectif vis-à-vis du silicium, par exemple, au moyen d'un bain d'acide phosphorique chaud suivi d'un bain d'acide fluorhydrique tamponé ou encore par un décapage par plasma d'ions fluor ou d'ions chlore.

Il est à remarquer que le positionnement des fenêtres d'alignement 28 n'est pas nécessairement très rigoureux car ce sont les dénivellations 23 laissées par la consommation de semiconducteurs ayant servi à former les éléments localisés 20 d'oxyde de silicium qui constituent la trace précise des motifs d'alignement en cours de réalisation.

La figure 5 montre le résultat obtenu à la suite des opérations aboutissant à la réalisation simultanée de l'oxyde de champ et des motifs d'alignement de masque. Ces opérations consistent à retirer le masque 22 et à soumettre le substrat semiconducteur à une seconde étape d'oxydation thermique à 1000° pendant 75 mm sous oxygène humide, permettant d'aboutir à des zones d'oxyde de champ 19′ d'une épaisseur de 500 nm telle qu'elle est désirée pour la suite du procédé d'élaboration du dispositif semiconducteur intégré, tandis que les motifs d'alignement 18 se trouvent oxydés en surface par le même traitement et ainsi revêtus d'une couche d'oxyde 24 d'une épaisseur voisine de 410 nm environ.

On peut remarquer que les motifs d'alignement 18 sont constitués d'une part à la surface de la couche d'oxyde 24 par des dénivellations 25 dont la forme est déduite directement des dénivellations 23 réalisées précédemment dans le matériau semiconducteur, et d'autre part par des dénivellations 26 situées à l'interface entre le semiconducteur 12 et la couche localisée d'oxyde 24, qui ont été formées par oxydation et sont obtenues par translation par rapport aux dénivellations 25. Au cours de cette translation, il se produit un léger élargissement de géométrie des dénivellations 26 qui se répartit de manière symétrique par rapport au centre des dénivellations du fait que le phénomène d'oxydation peut être considéré comme parfaitement isotrope à cette échelle de dimension. Que ce soit la surface supérieure de la couche d'oxyde 24, (si elle est ultérieurement métallisée) qui est utilisée optiquement pour une opération d'alignement, ou encore la surface du semiconducteur, dans tous les cas l'axe de symétrie de chaque motif d'alignement est parfaitement conservé et les opérations d'alignement de masques ultérieurs peuvent être très précis, en se référant au pas et à la position moyenne de l'ensemble des éléments des motifs.

Les figures 6 à 8 vont servir maintenant à décrire un deuxième exemple de réalisation du procédé selon l'invention. Dans cet exemple, les étapes qui ont été décrites à propos des figures 1 et 2 sont identiques.

Après avoir ouvert les fenêtres 17′ et 15′ dans la couche anti-oxydation 13 et comme indiqué à la figure 6, on recouvre l'ensemble par un masque 22 identique dans sa forme et sa nature au masque 22 décrit à propos de la figure 4. Il présente donc des fenêtres d'alignement 28 qui comprennent les motifs d'alignement 18. Dans les fenêtres d'alignement 28, on creuse alors directement dans le semiconducteur 12 des dénivellations (ou dépressions) 23 en se servant des portions restantes 13′ de la couche 13 de matériaux anti-oxydation, présentes dans ladite fenêtre, dépressions pratiquées sur une profondeur de 130 nm environ. Les dépressions 23 sont obtenues par décapage sélectif vis-à-vis du masque 22 de résine photosensible et vis à vis de la couche 13′ de matériaux anti-oxydation. Un mélange d'acides nitrique, fluorhydrique et acétique peut être utilisé à cet effet. Un décapage anisotrope, par plasma, peut également être utilisé et la sélectivité obtenue par exemple au moyen d'une sous-couche d'oxyde située sous la couche anti-oxydation 13.

Comme indiqué à la figure 7, on conserve le masque 22 et, dans les fenêtres d'alignement 28, on retire les parties restantes 13′ de couche anti-oxydation pour y mettre à nu la surface du substrat semiconducteur 12.

On retire alors le deuxième masque 28 et on soumet l'ensemble à un traitement d'oxydation thermique qui, en une seule étape, fournit l'épaisseur d'oxyde désirée pour l'isolation par oxyde de champ.

La figure 8 indique le résultat obtenu à la suite de cette étape. Ce résultat est très comparable à celui obtenu dans l'exemple précédent et décrit à la figure 4. Toutefois, la couche localisée d'oxyde 24′ homologue de la couche 24 de la figure 5 est ici de la même épaisseur que l'oxyde de champ 19′ puisque ces couches sont réalisées au cours de la même étape d'oxydation. Les motifs d'alignement 18 obtenus ici présentent à nouveau une surface supérieure d'oxyde qui comporte des dénivellations 25 conformes aux dénivellations 23 réalisées dans l'étape précédente à la surface du substrat semiconducteur, ainsi que des dénivellations 26 à l'interface semiconducteur/oxyde et qui présentent des propriétés géométriques et optiques qui conviennent à la fonction d'alignement précis des opérations ultérieures de masquages.

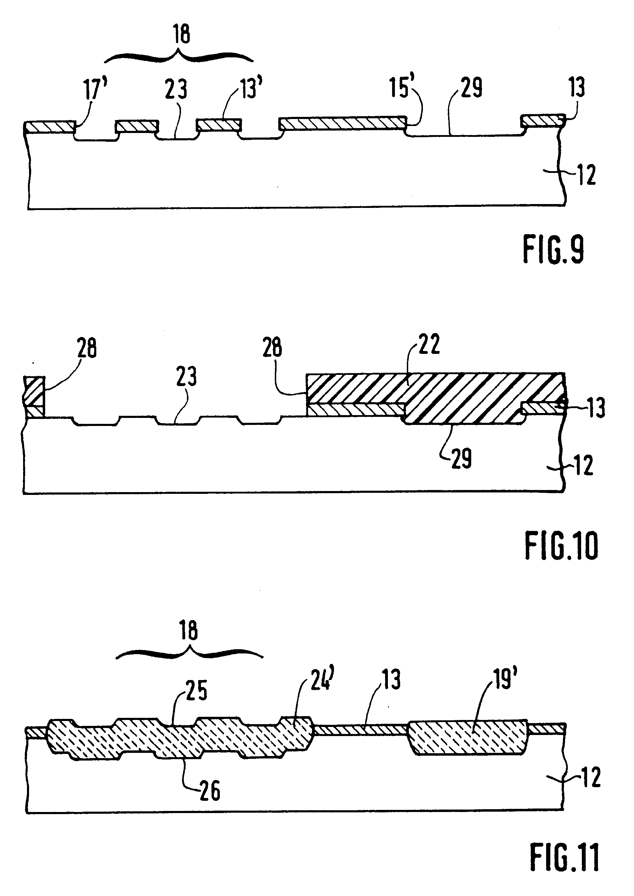

Une variante d'exécution du procédé qui vient d'être décrit est illustrée au moyen des figures 9 à 11. Selon cette variante, des dénivellations 23 correspondant aux motifs d'alignement 18, ainsi que des dénivellations 29 correspondant aux zones d'isolement par oxyde de champ sont réalisées par décapage sélectif en utilisant uniquement la couche anti-oxydation 13, munie des fenêtres 17′ et 15′, comme masque sélectif (voir figure 9). Le masque 22 de résine photosensible muni des fenêtres d'alignement 28 n'est appliqué qu'ensuite, figure 10, de manière à retirer les parties restantes 13′ de couche anti-oxydation uniquement dans lesdites fenêtres 28.

Ensuite, on retire le masque 22 et on procède, en une seule étape, à l'oxydation thermique pour la réalisation de l'oxyde de champ 19′ dans les zones correspondantes. Au cours de cette étape, (figure 11), les motifs d'alignement 18 se trouvent également oxydés par une couche 24′ de même épaisseur que l'oxyde de champ et qui comporte, comme à la figure 8 des dénivellations 25 et 26, respectivement à la surface supérieure de la couche d'oxyde 24′, et à l'interface entre cette couche et le substrat semiconducteur 12.

La seule différence de résultat par rapport au procédé décrit en référence à la figure 8 est qu'ici les zones d'oxyde de champ 19′ se trouvent légèrement enfoncées dans le substrat selon une profondeur correspondant aux dénivellations 29, creusées préalablement à l'oxydation.

## Revendications

1. Procédé pour réaliser des motifs d'alignement de masques sur une face active (11) d'un substrat semiconducteur (12) selon lequel on forme sur cette face active au moins une couche (13) d'un matériau résistant à l'oxydation, puis on définit par un décapage localisé de cette couche, des zones (15′) pour un isolement par un oxyde épais, dit oxyde de champ, en même temps que les motifs d'alignement (17′), l'un et l'autre étant destinés à être soumis à une oxydation thermique durant laquelle le reste de la surface active est protégé de l'oxydation par une partie restante de la couche (13) de matériau anti-oxydation, et lors d'une étape ultérieure, on réalise au moins à des emplacements qui contiennent les motifs d'alignement, emplacements dits fenêtres d'alignement (18), des dénivellations (23) à la surface du substrat (12), d'une profondeur déterminée,
caractérisé:
en ce qu'après le décapage localisé de la couche anti-oxydation (13) et en se servant des parties restantes de cette couche comme masque sélectif, on réalise d'abord lesdites dénivellations (23),
en ce que la surface du substrat est ensuite mise à nu à l'intérieur desdites fenêtres d'alignement (18),
en ce qu'ensuite on effectue une étape d'oxydation thermique pour la réalisation au moins partielle de l'oxyde de champ (19′) au cours de laquelle les motifs d'alignement (25, 26) sont simultanément recouverts d'oxyde (24), (24′).

2. Procédé selon la revendication 1, caractérisé:
en ce que lesdites dénivellations (23) sont réalisées par une étape spécifique d'oxydation thermique dans des conditions telles qu'elle conduit à une conversion en oxyde du semiconducteur sur une profondeur égale à ladite profondeur déterminée,
et en ce qu'après avoir mis à nu la surface du semiconducteur à l'intérieur desdites fenêtres d'alignement (18), on effectue l'étape d'oxydation déjà mentionnée pour la réalisation de l'oxyde de champ (19′) qui est complémentaire de l'étape spécifique d'oxydation.

3. Procédé selon la revendication 1, caractérisé:
en ce que lesdites dénivellation (23) sont réalisées par décapage sélectif, uniquement dans les fenêtres d'alignement (18) qui sont délimitées au moyen d'un masque de résine photosensible (22),
en ce qu'on retire ensuite, dans lesdites fenêtres (18) et avec le même masque, les parties restantes de couche anti-oxydation,
en ce qu'ensuite on retire le masque de résine photosensible (22) et on procède à une seule étape d'oxydation thermique pour la réalisation de l'oxyde de champ (19′).

4. Procédé selon la revendications 1, caractérisé:
en ce que lesdites dénivellations (23) sont réalisées par décapage sélectif, en utilisant uniquement la couche anti-oxydation (13) comme masque sélectif,
en ce qu'on retire ensuite, uniquement dans les fenêtres d'alignement (18) qui sont alors délimitées au moyen d'un masque de résine photosensible (22), les parties restantes de couche anti-oxydation (13),
en ce qu'ensuite on retire le masque de résine photosensible (22) et on procède à une seule étape d'oxydation thermique pour la réalisation de l'oxyde de champ (19′).

5. Procédé selon l'une des revendications 1 à 4, caractérisé:
en ce que ladite profondeur déterminée (d) des dénivellations (23) est voisine du 1/4 de la longueur d'onde de la lumière mise en oeuvre pour l'exploitation des motifs d'alignement.

6. Procédé selon la revendication 5, caractérisé:
en ce que ladite profondeur (d) des dénivellations (23) est comprise entre 100 et 150 nm et de préférence égale à 125 nm ± 10 nm.

## Patentansprüche

1. Verfahren zum Herstellen von Markierungen zum Justieren von Masken auf einer aktiven Oberfläche (11) eines Halbleitersubstrats (12), wobei zunächst mindestens eine Schicht (13) aus einem oxidationsbeständigen Material auf der genannten aktiven Oberfläche gebildet wird, wonach durch örtliches Ätzen dieser Schicht Zonen (15′) für Isolation durch ein dickes Oxid, bezeichnet als Feldoxid, gleichzeitig mit den Justiermarkierungen (17′) definiert werden und wobei während eines nachfolgenden Verfahrensschrittes die Zonen für die Isolierung durch Feldoxid und die auf diese Weise definierten genannten Justiermarkierungen eines thermischen Oxidation ausgesetzt werden, wobei der restliche Teil der aktiven Oberfläche durch einen restlichen Teil der Schicht (13) aus Antioxidationsmaterial vor Oxidation geschützt wird, und wobei während eines letzten Schrittes in den Gebieten, welche die Justiermarkierungen enthalten, wobei diese Gebiete Justierfenster (18) genannt werden, in der Oberfläche des Substrats (12) Einprägungen (23) einer bestimmten Tiefe vorgesehen werden, dadurch gekennzeichnet,
daß nach der örtlichen Ätzung der Antioxidationsschicht (13), wobei sich die restlichen Teile dieser Schicht als selektive Maske verhalten, die genannten Einprägungen (23) verwirklicht werden,
daß die Oberfläche des Substrats danach innerhalb der genannten Justierungsfenster (18) freigelegt werden,
daß danach ein thermischer Oxidationsschritt durchgeführt wird zur wengstens teilweisen Verwirklichung eines Oxidfeldes (19′), um das herum die Justierungsmarkierungen (25, 26) gleichzeitig von Oxid (24), (24′) befreit werden.

2. Verfahren nach Anspruch 1, dadurch gekennzeichnet,
daß die genannten Einprägungen (23) durch einen spezifischen thermischen Oxidationsschritt gebildet sind unter solchen Bedingungen, daß dies zu einer Umwandlung in Oxid des Halbleiters über eine Tiefe entsprechend der genannten bestimmten Tiefe führt und
daß nach der Freilegung der Oberfläche des Halbleiters innerhalb der genannten Justierungsfenster (18) der genannte Oxidationsschritt zum Bilden des Feldoxids (19′) durchgeführt wird, was zu dem spezifischen Oxidationsschritt hinzukommt.

3. Verfahren nach Anspruch 1, dadurch gekennzeichnet,
daß die genannten Einprägungen (23) durch selektives Ätzen nur innerhalb der Justierungsfenster (18) gebildet werden, die durch eine Maske aus photoempfindlichen Harz (22) definiert sind,
daß danach die restlichen Teile der Antioxidationsschicht in die genannten Fenster (18) und mit derselben Maske zurückgezogen werden, und daß danach die Maske aus photoempfindlichem Harz (22) entfernt und ein einziger thermischer Oxidationsschritt zur Bildung des Feldoxids (19′) durchgeführt wird.

4. Verfahren nach Anspruch 1, dadurch gekennzeichnet,
daß die genannten Einprägungen (23) durch selektives Ätzen gebildet werden, während nur die Antioxidationsschicht (13) als selektive Maske benutzt wird,
daß danach die restlichen Teile der Antioxidationsschicht nur innerhalb der Justierungsfenster (18) entfernt werden, die dann durch eine Maske aus photoempfindlichem Harz (22) definiert sind, und
daß danach die Maske aus photoempfindlichem Harz (22) entfernt wird und ein einziger thermischer Oxidationsschritt durchgeführt wird zum Bilden des Feldoxids (19′).

5. Verfahren nach einem der Ansprüche 1 bis 4, dadurch gekennzeichnet,
daß die genannte bestimmte Tiefe (d) der Einrpägungen (23) nahe 1/4 der Wellenlänge des verwendeten Lichtes zum Freilegen der Justierungsmarkierungen liegt.

6. Verfahren nach Anspruch 5, dadurch gekennzeichnet,
daß die genannte Tiefe (d) der Einrpägungen (23) zwischen 100 und 150 nm liegt und vorzugsweise dem Wert 125 nm ± 10 nm entspricht.

## Claims

1. A method of manufacturing mask alignment marks on an active surface (11) of a semiconductor substrate (12), whereby at least one layer (13) of a material resistant to oxidation is formed on this active surface, after which by a local etching of this layer zones (15) for insulation by a thick oxide, designated as field oxide, are defined simultaneously with the alignment marks (17′), and subsequently said zones and marks are to be subjected to a thermal oxidation during which the remainder of the active surface is protected from oxidation by a remaining portion of the layer (13) of anti-oxidation material, and in a further step, depressions (23) in the surface of the substrate (12) are created to a given depth at least in locations which contain alignment marks, which locations are called alignment windows (18), characterized in that, after local etching of the anti-oxidation layer (13) using the remaining portions of this layer as a selective mask, first said depressions (23) are formed, in that the surface of the substrate is then exposed within said alignment windows (18), and in that then a thermal oxidation step is carried out for forming the field oxide (19′) at least partly, during which step the alignment marks (25, 26) are simultaneously covered by oxide (24, 24′).

2. A method as claimed in Claim 1, characterized in that said depressions (23) are formed by a specific thermal oxidation step in conditions such that this step leads to a conversion of the semiconductor into oxide over a depth equal to said given depth and in that, after exposure of the surface of the semiconductor within said alignment windows (18), the oxidation step already mentioned for the formation of the field oxide (19′) is carried out, which complements to the specific oxidation step.

3. A method as claimed in Claim 1, characterized in that said depressions (23) are formed by selective etching solely in the alignment windows (18), which are defined by means of a mask of photosensitive resin (22), and in that then the remaining portions of the anti-oxidation layer are removed in said windows and with the same mask, and in that then the mask of photosensitive resin (22) is removed and a single thermal oxidation step is carried out for forming the field oxide (19′).

4. A method as claimed in Claim 1, characterized in that said depressions (23) are formed by selective etching using only the anti-oxidation layer (13) as a selective mask, in that then the remaining portions of the anti-oxidation layer (13) are removed in the alignment windows (18), which are then defined by means of a mask of photosensitive resin (22), and in that then the mask of photosensitive resin (22) is removed and a single thermal oxidation step is carried out for forming the field oxide (19′).

5. A method as claimed in any one of Claims 1 to 4, characterized in that said given depth (d) of the depressions (23) is close to 1/4 of the wavelength of the light utilized in conjunction with the alignment marks.

6. A method as claimed in Claim 5, characterized in that said depth (d) of the depressions (23) lies between 100 and 150 nm and is preferably equal to 125 nm ± 10 nm.
